Europäisches Patentamt

European Patent Office

Office européen des brevets

(11) Publication number: **0 481 543 A1**

# EUROPEAN PATENT APPLICATION

(21) Application number: **91202506.1**

(22) Date of filing: **26.09.91**

(51) Int. Cl.5: **H03H 17/02**

(30) Priority: **01.10.90 GB 9021348**

(43) Date of publication of application:
**22.04.92 Bulletin 92/17**

(84) Designated Contracting States:
**DE FR GB**

(71) Applicant: **PHILIPS ELECTRONICS UK LIMITED**
**Philips House 1-19 Torrington Place**
**London WC1E 7HD(GB)**

(84) **GB**

(71) Applicant: **N.V. Philips' Gloeilampenfabrieken**
**Groenewoudseweg 1**
**NL-5621 BA Eindhoven(NL)**

(84) **DE FR**

(72) Inventor: **Young, Bryan David**
**c/o Philips Research Laboratories**
**Redhill, Surrey RH1 5HA(GB)**

(74) Representative: **Moody, Colin James et al**
**PHILIPS ELECTRONICS Patents and Trade**
**Marks Department Philips House 1-19**
**Torrington Place**
**London WC1E 7HD(GB)**

(54) **Filtering arrangement.**

(57) The output of a COordinate Rotation by DIgital Computer (CORDIC) phase detection system at each step of its iterative procedure comprises a signal representing an iteration index number (r) and a polarity signal ($\delta_r$). These signals are used to address a pair of read only memories (70a,70b) which each contain both positive and negative values of the angular displacement $\theta_r$ for each iterative step premultiplied by a filter tap coefficient (a,b). The outputs ($\theta_r.a,\theta_r.b$) of the ROMs are added (72a,90a,72b,90b) separately over a complete set of iterative steps. One of the summed outputs is fed to a first non-inverting input of a signal combining means (94) and the other summed output is fed to a delay (92) whose output is fed to a second non-inverting input to the signal combining means. The output of the signal combining means (94) is fed to a further delay (96) whose output is fed to a third non-inverting input of the signal combining means. The output of the combining means (94) comprises a filtered angular displacement signal $\emptyset_r'(k)$.

FIG. 4

The present invention relates to a filtering arrangement for digital signals, having particular, but not exclusive, application for use as a loop digital filter within a Costas carrier frequency tracking loop in a direct conversion radio receiver.

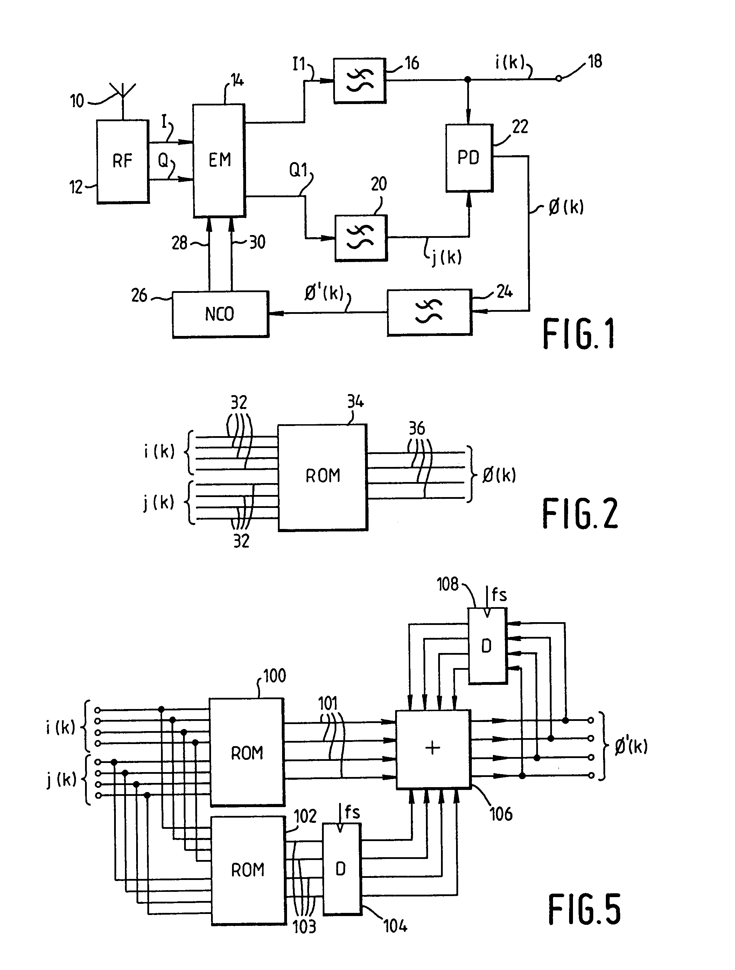

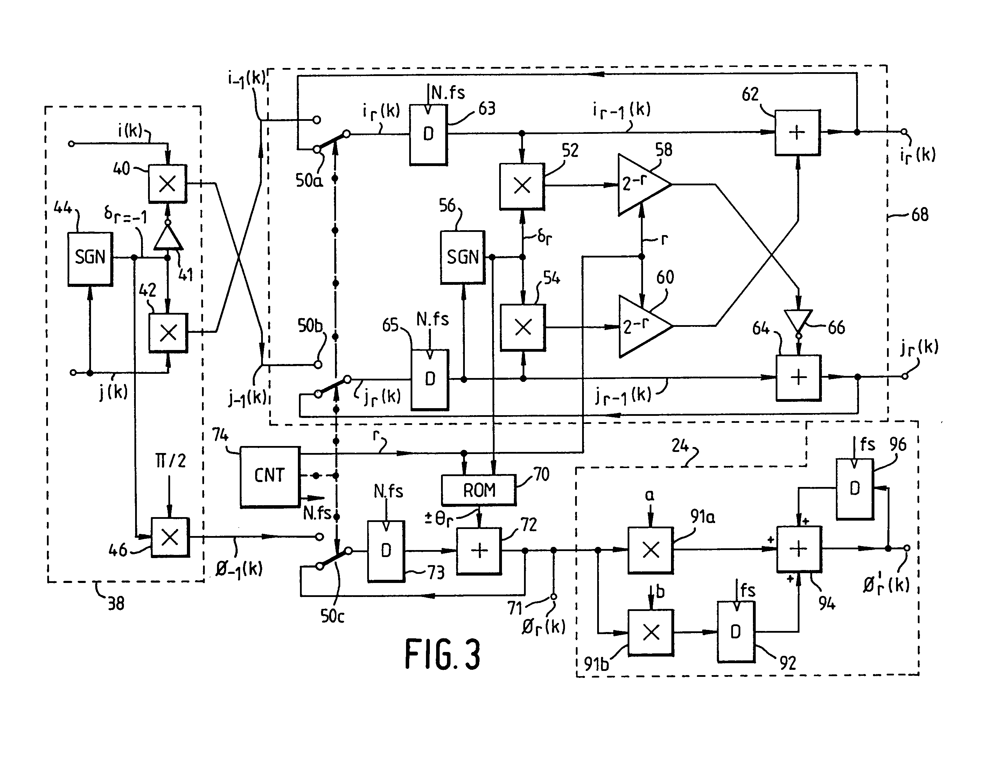

A direct conversion radio receiver incorporating a Costas loop of a type to which the present invention is applicable is shown in block schematic form in Figure 1 of the accompanying drawings. Radio signals are received by an antenna 10 and fed to a radio frequency (RF) stage 12 which mixes the incoming signals with signals from a first local oscillator (not shown) to give an in-phase signal I and a quadrature signal Q at a nominal intermediate frequency (IF). The two signals I, Q represent an input phasor and are both fed to an Exponential Multiplier (EM) 14 which also receives two quadrature related local oscillator signals 28,30 from a Numerically Controlled Oscillator (NCO) 26. The output of the EM is a pair of quadrature related signals I1, Q1 at baseband, in other words at zero intermediate frequency. The signal I1 is fed to a low pass filter 16 and the signal Q1 is fed to a low pass filter 20. The output of the filter 16 is an in-phase digital signal $i(k)$, where k is the sample number, and this signal is fed to an output terminal 18 and to a first input of a phase detector (PD) 22. The output of the filter 20 is a quadrature digital signal $j(k)$ and this signal is fed to a second input of the PD 22. If I1 and Q1 comprise analogue signals the two filters must include sampling or digitising means to provide $i(k),j(k)$. The output of the PD 22 is a phase signal $\emptyset(k)$ which is the angular distance between the phasor represented by $i(k)$ and $j(k)$ and the in-phase axis, in other words the phasor $i = 1$, $j = 0$. This phase signal $\emptyset(k)$ is fed to a low pass loop filter 24 whose output $\emptyset'(k)$ is fed to the NCO 26. The purpose of the Costas loop comprising the exponential multiplier 14, the phase detector 22, the filter 24 and the NCO 26 is to remove any elements of the residual carrier frequency present on the signals I, Q to allow data to be recovered from the in-phase digital signal $i(k)$ at the terminal 18. This is achieved by arranging for the NCO 26 to track the rotating component of the incoming phasor represented by I and Q. The phase detector, which may be likened to an arctangent function, generates correction signals which are fed to the NCO if the vector represented by the signals $i(k)$ and $j(k)$ departs from the in-phase axis. The filter 24 is included to maintain stability in the loop and will generally have a very low bandwidth of the order of 10 Hz.

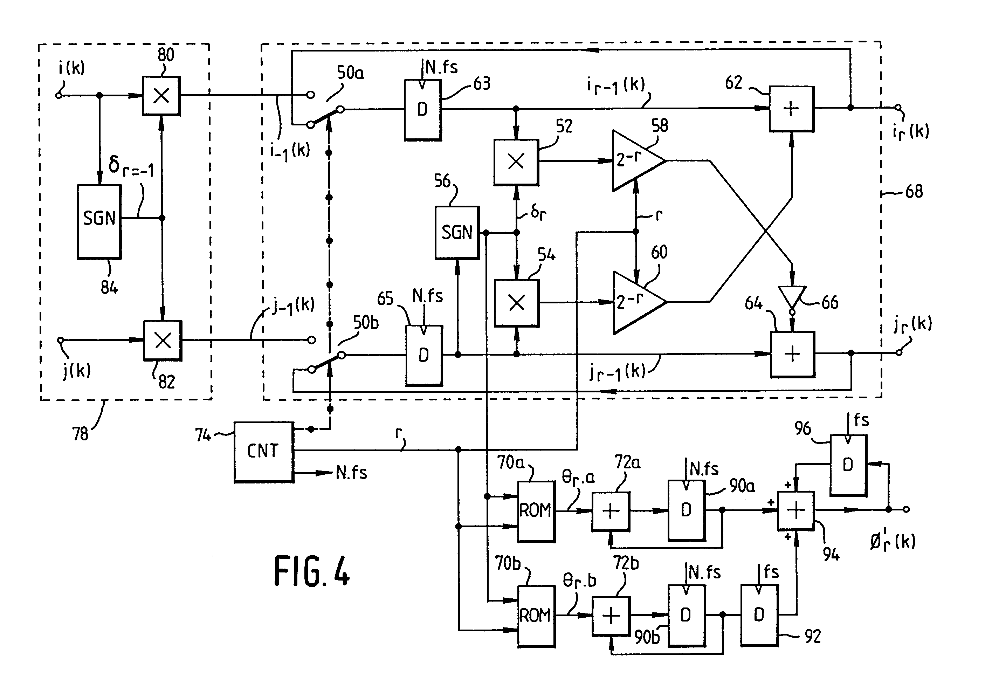

One means of realising the phase detector 22 is to use a look-up table comprising a Read Only Memory (ROM) and such a ROM is shown in Figure 2 of the accompanying drawings. The address lines 32 of the ROM 34 are coupled to receive the quadrature related digital signals $i(k),j(k)$ and the output $\emptyset(k)$ is provided from the ROM on data lines 36. Each location of the ROM 34 is programmed with a phase value corresponding to the angle represented by the combined values of $i(k)$ and $j(k)$.

Another means of realising the phase detector is to use an iterative procedure and an example of such a procedure is now described.

Figure 3 of the accompanying drawings shows a phase detection system which is described in "The CORDIC Trigonometric Computing Technique" by Jack E. Volder in IRE Transactions on Electronic Computers, September 1959 at pages 330-334 followed by a low pass loop filter. A brief summary of the CORDIC, which stands for COordinate Rotation by DIgital Computer, technique is included here. The baseband sampled in-phase digital signal $i(k)$ and the quadrature digital signal $j(k)$ which may be derived from the outputs of the filters 16,20 (Figure 1) are fed to a first input of a multiplier 40 and to a first input of a multiplier 42, respectively. The signal $j(k)$ is also fed to a sign determining means (SGN) 44. The output of the SGN 44 is a signal $\delta_{r=-1}$ of fixed amplitude whose polarity is the same as that of its input, and which is fed to the input of an inverter 41 and to a second input of the multiplier 42. The output of the inverter 41 is fed to a second input of the multiplier 40. The output of the multiplier 40 is a signal $j_{-1}(k)$ and the output of the multiplier 42 is a signal $i_{-1}(k)$. The output of the sign determining means 44 is also fed to a first input of a multiplier 46 also having a second input which is fed with a constant scalar value equivalent to an angle of $\Pi/2$ radian. The output of the multiplier 46 is a signal $\emptyset_{-1}(k)$. The section of the system shown in Figure 3 thus far described is enclosed in a box 38 indicated in broken lines and its function is as follows. If the incoming phasor represented by the signals $i(k)$ and $j(k)$ lies in the first quadrant both $i(k)$ and $j(k)$ will be positive and so will the output $\delta_{r=-1}$ of the SGN 44. The signal $\delta_{r=-1}$ is inverted by the inverter 41 and applied to the multiplier 40 so that the input $i(k)$ is inverted in the multiplier 40 and becomes the signal $j_{-1}(k)$. The signal $j(k)$ is multiplied by $\delta_{r=-1}$ in the multiplier 42 and becomes the signal $i_{-1}(k)$. The effect of this inversion and reversal is that the input phasor has been rotated through $\Pi/2$ radian in a clockwise direction and now lies in the fourth quadrant. If the incoming phasor lies in the fourth quadrant, both $j(k)$ and $\delta_{r=-1}$ will be negative and so in this case $j(k)$ will be inverted in the multiplier 42 and the phasor will be rotated anticlockwise through $\Pi/2$ radian and will lie in the first quadrant. By similar reasoning, an input phasor lying in the second or third quadrants will be rotated by the section 38 to lie in the first or fourth quadrants, respectively. The multiplier 46 calculates the rotation applied to the incoming phasor by this first stage and the result of this calculation is a signal $\emptyset_{-1}(k)$.

The remaining section 68 of the implementation of the CORDIC algorithm shown in Figure 3 is concerned with performing an iterative procedure to determine that portion of $\emptyset(k)$ remaining after the first rotation. This portion of $\emptyset(k)$ is an intermediate phasor represented by $i_{-1}(k)$ and $j_{-1}(k)$. A total of (N-1) iterations are performed by the section 68, numbered 0 to (N-2), which are denoted by an index number r. The iteration number r = -1 is the $\pm\Pi/2$ radian rotation performed by the section 38 and described above. The magnitude of the rotation at each iteration is determined by what can be effected using one or more rotate to the right procedures on the binary bits of the input data and so N must be less than the number of bits used to represent the incoming data. Using a rotate to the right technique in this manner allows the CORDIC algorithm to avoid using complex and computationally intensive multiply or divide routines and it was for this reason that it was originally devised.

The operation of the CORDIC algorithm is under the control of a counting means (CNT) 74 which will count at a rate of N.fs, to provide the iteration index number r, where fs is the data rate of the incoming signals i(k),j(k) and N is the total number of iterations performed. A clock signal at a rate of fs will already be available from elsewhere within the receiver. The signal $i_{-1}(k)$ from the section 38 is fed to a first input of a single pole two way switch 50a and the signal $j_{-1}(k)$ from the section 38 is fed to a first input of a single pole two way switch 50b. The signal $\emptyset_{-1}(k)$ from the multiplier 46 is fed to a first input of a single pole two way switch 50c. Each of the three switches 50a, 50b and 50c has a first input, a second input, and a moving contact which can connect an output to either of the inputs. The three switches are ganged together so that their outputs are either all connected to their first respective inputs or to their second respective inputs simultaneously. In the drawing the outputs of the switches are shown connected to their second inputs. The position of the switches is controlled by the counting means (CNT) 74 such that at the end of the first iteration, r = -1, the outputs of the switches are connected to their first inputs to receive the signals $i_{-1}(k)$, $j_{-1}(k)$, $\emptyset_{-1}(k)$ and for the remainder of the iterative process the outputs of the switches are connected to their second inputs to receive the signals $i_r(k)$, $j_r(k)$, $\emptyset_r(k)$. The output of the switch 50a is fed to a D-type flip-flop 63 having a clock rate of N.fs. The output of the flip-flop 63 is fed to a first input of a multiplier 52 and to a first input of a summer 62. The output of the switch 50b is fed to a D-type flip-flop 65 having a clock rate of N.fs. The output of the flip-flop 65 is fed to a first input of a multiplier 54, to a first input of a summer 64 and to a sign determining means (SGN) 56. The output of the SGN 56 is a signal $\delta_r$ which is fed to a second input of the multiplier 52, to a second input of the multiplier 54 and to a first input of a read only memory (ROM) 70. The output of the multiplier 52 is fed to a first shift to the right means 58 which shifts the multiplier output by a number of bits equal to the iteration number r. This shift to the right means may be considered as a gain stage with a gain of $2^{-r}$. The value of the iteration index number r is fed to the means 58 and also to a second shift to the right means 60 by the CNT 74. The output of the means 58 is fed to the input of an inverter 66 and the output of the inverter 66 is fed to a second input of the summer 64. The output of the summer 64 is a quadrature output signal $j_r(k)$ which is fed to the second input of the switch 50b. The output of the multiplier 54 is fed to the second shift to the right means 60, whose output is fed to a second input of the summer 62. The shift to the right means 60 operates in the same manner as the shift to the right means 58. The output of the summer 62 is an in-phase output signal $i_r(k)$ which is fed to the second input of the switch 50a. The section of Figure 3 described in this paragraph with the exception of the ROM 70, the CNT 74 and the switch 50c forms an iterative rotation section which is shown enclosed in a box 68 illustrated in broken lines.

The output of the switch 50c is fed to a D-type flip-flop 73 having a clock rate of N.fs. The output of the flip-flop 73 is fed to a first input of a summer 72. A second input of the summer 72 is fed from the output $\pm\theta_r$ of the ROM 70. The ROM 70 holds a set of values $\theta_r$ which correspond to the angular rotation at each iteration and also holds the negatives of those values, it is addressed by the iteration number r and the output signal $\delta_r$ of the SGN 56. The signal $\delta_r$ determines the polarity of the rotation signal which is fed to the summer 72. The output of the summer 72 is a phase output signal $\emptyset_r(k)$ which is available at a terminal 71 and which is fed to the second input of the switch 50c.

In operation the iterative rotation section 68 of the phase detection system receives quadrature related signals which represent phasors lying in either the first or the fourth quadrants. If an input lies in the first quadrant, $i_r(k)$, $j_r(k)$, $\delta_r$ will be positive with the effect that the outputs of the multipliers 52 and 54 will have polarities which are the same as their inputs. The signal $i_{r-1}(k)$ will be multiplied by $2^{-r}$ by the first shift to the right means 58 and inverted by the inverter 66 prior to being fed to the summer 64. In the summer 64 this inverted signal will be added to the output of the flip-flop 65 to provide the $j_r(k)$ output signal. The signal $j_{r-1}(k)$ will be multiplied by $2^{-r}$ by the second shift to the right means 60 and added to the output of the flip-flop 63 in the summer 62 to give the $i_r(k)$ output signal. At each step of the iteration if the imaginary or quadrature component $j_{r-1}(k)$ of the phasor is positive, the phasor will be rotated in a clockwise direction. If the imaginary component of the phasor is negative, the phasor will be rotated in an anti-clockwise direction. The magnitude of the angle through which the phasor is rotated at each iteration is equal to arctan $(2^{-r})$ so at iteration number 0 the angle is equal to arctan (1) or $\Pi/4$ radian. The ROM 70 provides the angular magnitude and the sign of the rotation at each iteration so the output of this ROM may be positive or negative as determined by the signal $\delta_r$. The summer 72 together with the flip-flop 73 maintain a cumulative total of the angles through which the phasor has been rotated since the start of each series of iteration steps. In a similar manner, the summer 62 together with the flip-flop 63 maintain a cumulative total of the changes in the magnitude of the vector $i_r(k)$. The iteration proceeds either until the final iteration step or until a comparison device (not shown) determines that the error in the value of $\emptyset_r$-(k) is small enough. When a comparison device is not provided, after the last iteration the index number r = (N-2) and so $i_r(k) = i_{N-2}(k)$, $j_r(k) = j_{N-2}(k)$,$\emptyset_r$-(k) = $\emptyset_{N-2}(k)$. The signal $j_{N-2}(k)$ should be very small and the signals $i_{N-2}(k)$ and $\emptyset_{N-2}(k)$ should give the magnitude and the phase angle of the input phasor, respectively. The iteration number r is reset to -1, the flip-flops 63,65,73 are cleared and the process repeats itself.

When it is being used within a Costas loop the CORDIC algorithm need only provide the phase signal $\emptyset_{N-2}(k)$ to the NCO 26 (Figure 1) although the magnitude signal $i_{N-2}(k)$ may be of interest when a range of the frequency spectrum is being searched by a receiver for signals of differing strengths.

When a phase detection system of the type described above is used within a Costas loop, a loop filter 24 is included after the detector to stabilise the loop. One suitable loop filter has a transfer function of:

$$\emptyset'(k) = a\emptyset(k) + b\emptyset(k-1) + \emptyset'(k-1)$$

which is a first order infinite impulse response (IIR) filter having two tap coefficients a and b. Either or both of the tap coefficients a,b may be negative. A filter 24 having this transfer function is shown in block schematic form within the box shown in broken lines in Figure 3.

An output signal $\emptyset_r(k)$ from the output of the summer 72 is fed to a first input of a multiplier 91a and to a first input of a multiplier 91b. A second input of the multiplier 91a is fed with a first filter tap coefficient a and a second input of the multiplier 91b is fed with a second filter tap coefficient b. The output of the multiplier 91a is fed to a non-inverting input of a summer 94. The output of the multiplier 91b is fed to a D-type flip-flop 92 having a clock frequency of fs. The output of the flip-flop 92 is fed to a non-inverting input of the summer 94. The output of the summer 94 comprises a filtered angular signal $\emptyset'_r(k)$ which is fed to a D-type flip-flop 96 having a clock frequency of fs. The output of the flip-flop 96 is fed to a non-inverting input of the summer 94. The filter 24 is clocked so that the signal $\emptyset_r(k)$ is only accepted as an input after the final iteration of the section 68 and $\emptyset_r(k) = \emptyset_{N-2}(k)$.

The operation of the filter 24 requires two multiplications to be performed in the multipliers 91a, 91b, the first by the filter tap coefficient a, and the second by the filter tap coefficient b which multiplications can substantially increase the overall computational load resulting from the use of the IIR filter 24.

It is an object of the present invention to provide a filtering arrangement for digital signals in which the multiplications of the incoming signal by the filter tap coefficients result in a reduced computational complexity.

According to a first aspect of the present invention there is provided a filtering arrangement for a digital signal represented by a plurality of bits, comprising at least a first look-up table and a second look-up table which are both addressed by the said plurality of bits, the first look-up table containing a plurality of data values premultiplied by a first scalar constant and the second look-up table containing the plurality of data values premultiplied by a second scalar constant, an output of the first look-up table being coupled to a first input of a signal combining means, an output of the second look-up table being coupled to the input of a delay means, an output of the delay means being coupled to a second input of the signal combining means and the output of the signal combining means comprising an output of the filtering arrangement.

The above described arrangement provides a first order finite impulse response (FIR) filter for a digital signal. By feeding the output of the filtering arrangement to a delay means and feeding the output of this delay means to a further input of the signal combining means, an infinite impulse response (IIR) filter can be constructed. The signal or signals fed back in this manner may be scaled in magnitude prior to being fed to the signal combining means and one means of so doing is to include a ROM look-up table in the feedback signal path.

The digital signal for which the filtering arrangement is provided may represent an intermediate signal, for example the numerical output of one step of an iterative process. In this case the filtering means may include separate summing means coupled to the output of each look-up table which summing means are operable to add the outputs of all of the iterative steps and then to feed the final output of the iterative process to the signal combining means.

Typically the at least two look-up tables will comprise Read Only Memories (ROMs) but if, for example, Random Access Memories (RAMs) or other dynamically alterable memory means are used as the look-up tables then the characteristics of the filtering arrangement could be altered in use.

A second aspect of the present invention provides a filtering arrangement for a digital signal represented by a plurality of bits which comprises the output of an iterative system, comprising at least a first look-up table and a second look-up table which are both addressed by the said plurality of bits, the first look-up table containing a plurality of data values premultiplied by a first scalar constant and the second look-up table containing the plurality of data values premultiplied by a second scalar constant, an output of the first look-up table being coupled to an input of a first summing means whose output is coupled to a first input of a signal combining means, an output of the second look-up table being coupled to an input of a second summing means whose output is coupled to a second input of the signal combining means, the summing means being operable to add the outputs of the iterative system over at least a complete set of iterative steps and at least one of the summing means being operable to add a respective output of the iterative system over a plurality of sets of iterative steps, and the output of the signal combining means comprising an output of the filtering arrangement.

According to a third aspect of the present invention there is provided a radio receiver comprising at least a first frequency down conversion stage for providing quadrature related outputs, a further frequency down conversion stage having signal inputs connected to receive the quadrature related outputs of the first frequency down conversion stage, the further frequency down conversion stage comprising a local oscillator having a control input and a pair of quadrature related outputs and a means for multiplying the signal inputs and the local oscillator outputs to provide a first and a second output in phase quadrature, the outputs of the further frequency down conversion stage being coupled to inputs of first and second filtering means respectively, an output of the first filtering means comprising an output of the receiver and being fed to a first input of a phase detection and filtering means, an output of the second filtering means being fed to a second input of the phase detection and filtering means which has an output coupled to the control input of the local oscillator, the output signals from the first and second filtering means comprising an input phasor to the first and second inputs of the phase detection and filtering means, characterised in that the phase detection and filtering means comprises means for rotating the input phasor to produce an intermediate phasor which lies in one of two adjacent angular quadrants, means for rotating the intermediate phasor in a series of iterative steps through a plurality of successively decreasing angular displacements towards an axis common to the two adjacent angular quadrants, means for counting the index number of each iterative step and applying the index number to at least two look-up tables containing entries which are equal to products of the angular displacements premultiplied by different scalar constants, means for modulating the polarity of the outputs of the at least two look-up tables in response to the direction of the angular displacement for each iterative step and at least a first and a second means coupled to the look-up tables for summing their outputs over a complete series of iterative steps, the output of the first summing means is coupled to the input of a delay means whose output is coupled to an input to a signal combining means, the output of the second summing means is coupled to another input of the signal combining means, the output of the signal combining means is coupled to at least one further delay means, the output of the or each further delay means is coupled to the or a respective further input of the signal combining means and the output of the signal combining means comprises the output of the phase detection and filtering means.

The phase detection means of the radio receiver in accordance with the present invention performs a different first rotation to that of the phase detection system shown in Figure 3. Binary phase shift keyed (BPSK) signals have 180° or $\Pi$ radian shifts in phase that represent the data and a radio receiver used to receive these signals must not track these changes otherwise the data will be lost. Consequently the first rotation stage of the above described receiver performs a 180° or $\Pi$ radian shift on the incoming signal if the phasor representing the incoming signal lies in the third or fourth angular quadrants and no record is made of this shift. Consequently the BPSK data phase changes on the incoming signal are left intact.

The radio receiver in accordance with the present invention includes a Costas carrier frequency tracking loop and the means for multiplying the signal inputs with the local oscillator outputs in such a loop may be an exponential multiplier. An exponential multiplier will usually generate fewer unwanted harmonics at its output than a pair of mixers used to perform the same function and this may permit the specifications of the first and second filtering means to be relaxed.

The loop filter within the phase detection and filtering means described above is a first order infinite impulse response (IIR) filter. By the addition of further input and feedback stages a higher order filter is realisable. A scaling device may be included in series with these further feedback stages to modify the amplitude of the fed-back signal.

The outputs of the at least two look-up tables must be modulated in accordance with the polarity of the rotation at each iterative step and a number of methods for so doing will be apparent to those skilled in the art. One possible method is to use a look-up table that contains entries for both the positive and negative values of the premultiplied angular displacements arranged so that the alteration of the value of one address bit will alter the polarity of the output signal from the look-up table. A second possible method requires that the first and second summing means have an input which is coupled to the output of the look-up table which may be reversed in polarity so that they either behave as adders or subtractors in response to a control signal. This may also be thought of as switching an inverter into or out of the signal path between the look-up tables and the summing means.

The bandwidth of the loop filter may need to be varied in operation, for example to have a wide bandwidth during a search for a radio signal and a narrow bandwidth to track the signal once it has been found. This may be achieved using a radio receiver in accordance with the present invention by realising the at least two look-up tables as dynamically alterable memory devices such as Random Access Memories (RAMs). When required, a new set of data values could be loaded into the look-up tables or the current entries could be multiplied by a scalar constant to provide new look-up table entries.

The present invention will now be explained and described, by way of example, with reference to Figures 4, 5, 6, 7a and 7b of the accompanying drawings, wherein:

Figure 4 is a block schematic diagram of a phase detection system followed by a filtering arrangement in accordance with the present invention,

Figure 5 is a block schematic diagram of an alternative phase detection system and a filtering arrangement incorporating a first order IIR filter,

Figure 6 is a block schematic diagram of an extension to the system shown in Figure 5 to provide a second order IIR filter,

Figure 7a is a block schematic diagram of a first order filtering arrangement, and

Figure 7b is a block schematic diagram of the first order filtering arrangement implemented in accordance with the present invention.

Features of the system shown in Figures 4 to 7 which correspond to those shown in Figures 2 and 3 have been identified using the same reference numerals.

In Figure 4 an input phasor is represented by an in-phase signal i(k) and a quadrature signal j(k) which may be derived as shown in Figure 1. The in-phase signal i(k) is fed to an input of a sign determining means (SGN) 84 and to a first input of a multiplier 80. The quadrature signal j(k) is fed to a first input of a multiplier 82. The output of the SGN 84 is a signal $\delta_{r=-1}$ which is fed to the second inputs of the multipliers 80,82. The output of the multiplier 80 is a signal $i_{-1}(k)$ and the output of the multiplier 82 is a signal $j_{-1}(k)$. The section of the system shown in Figure 4 thus far described is enclosed in a box 78 indicated in broken lines and its purpose is to rotate the phasor represented by the signals i(k) and j(k), if necessary, to lie in the first or fourth quadrant. If the incoming phasor lies in the second or the third quadrants the signal i(k) will be negative, the output $\delta_{r=-1}$ of the SGN 84 will also be negative and the effect of the multipliers 80,82 will be to make $i_{-1}(k) = -i(k)$ and $j_{-1}(k) = -j(k)$ respectively. These inversions are equivalent to a $\Pi$ radian rotation of the phasor represented by the signals i(k),j(k). If the incoming phasor lies in the first or fourth quadrants, the signal $\delta_{r=-1}$ will be positive and the multipliers 80,82 will have no effect so that the signals $i_{-1}(k) = i(k)$ and $j_{-1}(k) = j(k)$. The reason for this method of rotation, as opposed to that shown in Figure 3, is so that any BPSK data present on the signals i(k),j(k) will not be lost as described previously.

The outputs $i_{-1}(k),j_{-1}(k)$ of the section 78 are then fed to an iterative rotation section 68 which is identical with that of Figure 3. Accordingly in the interests of brevity the description of this section of the phase detection system will not be repeated. Since the initial $\Pi$ radian phase rotation performed by the section 78 is not recorded, the multiplier 46 and the switch 50c (Figure 3) have been omitted.

The remainder of the system shown in Figure 4 is concerned with the production of two scaled angular displacements and the filtering of the output of the CORDIC algorithm. A counting means (CNT) 74 has an output r which is the iteration number, controls the two switches 50a,50b and provides a clock signal N.fs in the same manner as that of the system shown in Figure 3. A ROM 70a contains a set of scaled angular displacements $\theta_r.a$ which are equal to those held in the ROM 70 (Figure 3) multiplied by a constant a and a ROM 70b contains a set of scaled angular displacements $\theta_r.b$ which are equal to those held in the ROM 70 multiplied by a constant b. The constants a and b are filter coefficients determined in a conventional manner as known from, for example, "Theory and Application of Digital Signal Processing" by L. Rabiner and B. Gold, Prentice Hall 1975. The two ROMs 70a,70b will typically contain the scaled angular displacements with a resolution of 16 to 18 bits and also include the inverses of the displacements. The two ROMs 70a,70b are both addressed in the same manner, their most significant address bit being fed from the output $\delta_r$ of the SGN 56 and their remaining address bits being fed with the iteration index number r provided by the CNT 74. By rearranging the contents of the ROMs 70a,70b an address bit other than the most significant one could be addressed by the signal $\delta_r$ and used as a polarity reversing input. The output $\theta_r.a$ of the ROM 70a is fed to a first non-inverting input of a summer 72a, the output of which summer is fed to the input of a D-type flip-flop90a. The clock input of the flip-flop 90a is fed from the N.fs clock signal supplied by the CNT 74. The contents of the flip-flop 90a are reset to zero at the start of each series of iterations. The output of the flip-flop 90a is fed to a second non-inverting input of the summer 72a and to a non-inverting input of a summer 94. The output $\theta_r.b$ of the ROM 70b is fed to a first non-inverting input of a summer 72b whose output is fed to a D-type flip-flop 90b. The clock and reset connections for the flip-flop 90b are the same as those of the flip-flop 90a. The output of the flip-flop 90b is fed to a second non-inverting input of the summer 72b and to an input of a D-type flip-flop 92. The flip-flop 92 is used as a delay of one sampling period and so its clock line is fed with a signal at a frequency of fs. The output of the flip-flop 92 is fed to a non-inverting input of the summer 94. The output of the summer 94 is a filtered phase error signal $\emptyset'_r(k)$ which comprises the output of the system. The signal $\emptyset'_r(k)$ is additionally fed to a D-type flip-flop 96 and may be fed to a NCO 26 (Figure 1). The clock rate of the flip-flop 96 is fs and its output is fed to a non-inverting input of the summer 94.

The arrangement shown in Figure 4 thus performs the phase detection and the necessary loop filtering for a Costas loop to the same standard as the arrangement shown in Figure 3 but the multiplications which require the two multipliers 91a,91b have been eliminated.

The filter shown in Figure 4 is a first order infinite impulse response (IIR) filter which should be adequate for most Costas loop applications but in a highly dynamic system where either the transmitter or receiver (or both) are moving very quickly and imposing a dynamic Doppler shift on the received signals, a second or higher order filter may be required.

In the case of a second order filter, one extra filter tap will be required, in the case of a third order filter, two extra filter taps will be required and so on. Each extra tap provided by the filter will require an extra branch feeding the summer 94 and an extra feedback loop around the summer 94. Each branch may comprise the following components. A look-up table which contains the scaled angular increments and is addressed by the iteration number r and the output $\delta_r$ of the SGN 56. A summer having a first input which is fed from the output of the look-up table. The output of the summer is fed to a D-type flip-flop whose clock is the fs.N signal provided by the CNT 74. The output of the flip-flop is fed to a second input of the summer and to another D-type flip-flop which is clocked at a rate of fs. This last mentioned flip-flop is used as a delay and the length of the delay required depends upon the number of extra taps required to achieve the desired order of the filter. The length of the delay in the filter branch with the longest delay will be longer than the shortest delay by a factor equal to the order of the filter. This can be achieved by using a plurality of cascaded delay stages and the output of the final delay stage is fed to an inverting input of the summer 94. Further delay stages are required to form extra feedback loops around the summer 94 and again the longest loop delay will depend upon the number of taps of the filter.

The ROMs 70a,70b could also be arranged to contain only positive angular displacements and the first input to each of the summers 72a,72b would then be a polarity reversible input which is either a non-inverting input or an inverting input under the control of the signal $\delta_r$.

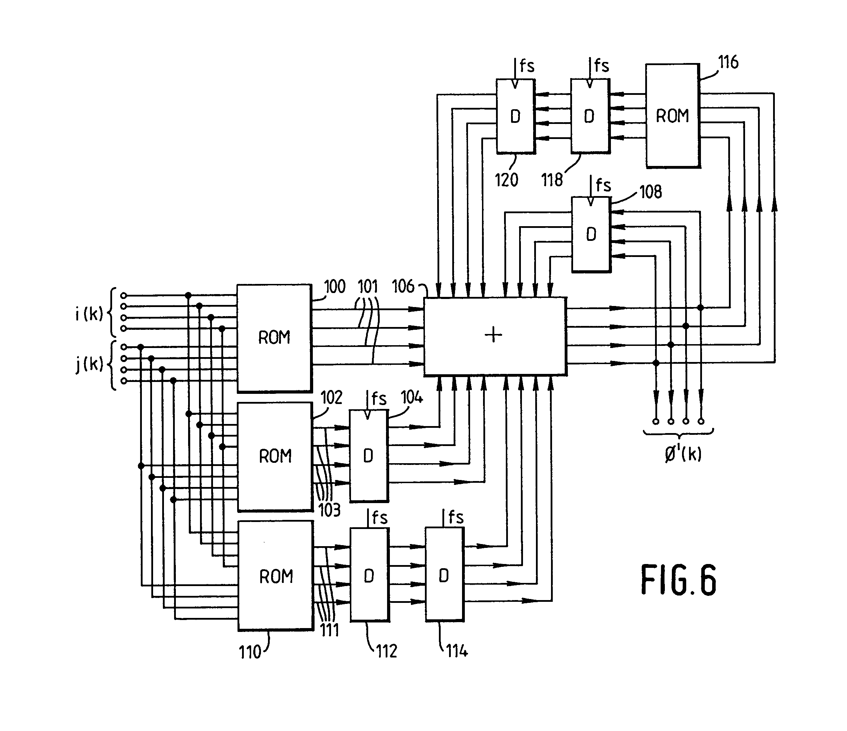

Figure 5 shows an alternative embodiment of a phase detection system and filtering arrangement which does not incorporate an iterative section. The input signals i(k),j(k) are used to directly address a pair of look-up tables comprising ROMs 100,102. These two ROMs each contain a scaled angular displacement for every possible permutation of the values of the two input signals i(k),j(k) and consequently may be quite large. The data lines 101 of the ROM 100 are fed to a first non-inverting input of a summing device 106. The data lines 103 of the ROM 102 are coupled to an input of a D-type flip-flop 104 which is clocked at a rate of fs, the sampling rate of the input signals. The outputs of the flip-flop 104 are fed to a second non-inverting input of the summing device 106. An output of the summing device 106 comprises a filtered angular displacement signal $\emptyset'(k)$ which is fed to an input of a D-type flip-flop 108 which is clocked at a rate of fs. The output of the flip-flop 108 is coupled to a third non-inverting input of the summing device 106.

In operation the two ROMs 100,102 each provide an angular displacement on their data lines which has been pre-multiplied by a filter tap coefficient. Consequently no further multiplications of the angular displacement by filter tap coefficients are required before filtering. Again, if only a finite impulse response filter is required, the flip-flop 108 may be eliminated or if the feedback signal via the flip-flop 108 is to be at a magnitude other than unity, a scaling device should be included in series with the flip-flop 108.

Figure 6 shows a second order infinite impulse response (IIR) filter which operates on the same principles as the first order filter of Figure 5. The input signals i(k),j(k) are used to directly address three look-up tables comprising ROMs 100,102,110. These ROMs each contain a scaled angular displacement for every possible permutation of the values of i(k),j(k). The data lines 101 of the ROM 100 are fed to a first non-inverting input of a summing device 106. The data lines 103 of the ROM 102 are fed to an input to a D-type flip-flop 104 which is clocked at a rate of fs, the sampling rate of the input signals. The outputs of the flip-flop 104 are fed to a second non-inverting input to the summing device 106. The data lines 111 of the ROM 110 are fed to a D-type flip-flop 112 which is clocked at a rate of fs. The output of this flip-flop is fed to a further D-type flip-flop 114 which also clocked at a rate of fs. The output of the flip-flop 114 is fed to a third non-inverting input of the summing device 106. The output of the summing device 106 is fed to the address lines of a look-up table comprised of a ROM 116 and to a D-type flip-flop 108 which is clocked at a rate of fs. The data lines of the ROM 116 are fed to a D-type flip-flop 118 which is clocked at a rate of fs. The output of the flip-flop 118 is fed to a further D-type flip-flop 120 which is also clocked at a rate of fs. The output of the flip-flop 120 is fed to a fourth non-inverting input to the summing device 106. The output of the flip-flop 108 is fed to a fifth non-inverting input of the summing device 106. The output of the summing device 106 comprises the filtered angular displacement signal $\emptyset'(k)$.

In operation, the outputs of the ROMs 100,102,110 will comprise the angular displacement represented by the input phasors i(k),j(k) from the in-phase axis, scaled by different filter parameter values. The output of the ROM 102 will be delayed by one clock period in the flip-flop 104 as in the embodiment shown in Figure 5. The output of the ROM 110 is delayed by two clock periods in the cascaded flip-flops 112 and 114. As in the system of Figure 5 the first order feedback via flip-flop 108 has a gain of unity. However, the system shown in Figure 6 has a second order feedback loop via the cascaded flip-flops 118,120 and there are only a very small number of second order filter transfer functions in which the feedback in both paths possesses unity gain. Consequently the ROM look-up table 116 is included in the second order feedback path to scale the magnitude of the second order feedback signal. Each address location of the ROM 116 contains a value which is equal to its address number multiplied by the desired second order feedback coefficient. Taking an example with just a positive coefficient, if the feedback coefficient is equal to a half, the location at address 1010b of the ROM 116 will contain a value of 0101b. The output of the ROM 116 is then delayed by two clock periods in the flip-flops 118,120 before being fed to the summing device 106. As before, the output $\emptyset'(k)$ of the arrangement is taken from the output of the summing device 106.

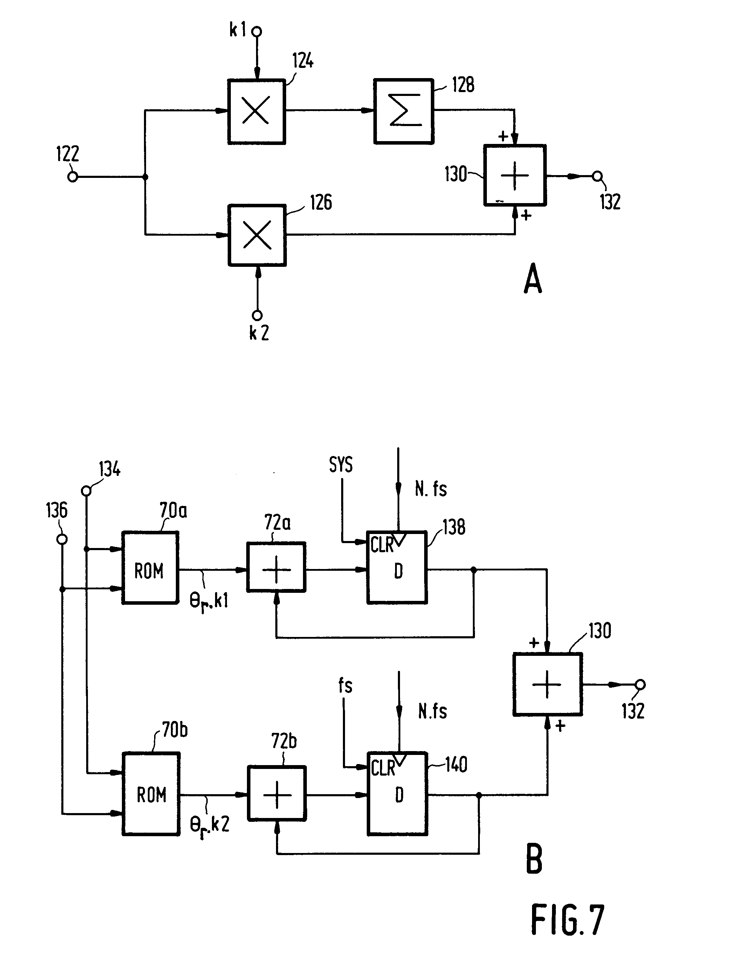

An alternative filter topology may also be used with the present invention. Figure 7a is a block schematic diagram of a first order filter having an input terminal 122 which is coupled to a first input of each of a pair of multipliers 124, 126. Second inputs of the multipliers are supplied with constants k1 and k2 respectively. The output of the multiplier 124 is fed to an acumulator 128 which operates to add the previous output of the multiplier 124 to its present output. The output of the accumulator 128 is fed to a first input to a summer 130 whose second input is supplied with the output of the multiplier 126. The output of the summer 130 comprises the output of the filter.

The filter shown in Figure 7a requires two multiplications by coefficients, an accumulate stage and a summation. As described with reference to Figure 4, the multiplications by coefficients may be incorporated into look-up tables and permit the multipliers 124,126 to be dispensed with.

Figure 7b shows an arrangement in which the function of the accumulate stage 128 is performed by the accumulate stage provided at the output of an iterative system, for example the CORDIC phase detector shown in Figure 4.

A pair of input terminals 134,136 are coupled to the address lines of a pair of ROMs 70a,70b. The terminals 134,136 are coupled to the output of the SGN56 (Figure 4) and the output r of the CNT 74 (Figure 4), respectively. The output of the ROM 70a is a signal $\theta_r.k1$ which is fed to a first input to a summer 72a whose output is fed to an input to a D-type flip-flop 138. The clock terminal of the flip-flop 138 is supplied with a signal having a rate of N.fs and the clear (CLR) terminal of the flip-flop is supplied with a system reset (SYS) signal. The output of the flip-flop 138 is fed to a second input to the summer 72a and to a first input of a summer 130. The output of the ROM 70b is a signal $\theta_r.k2$ which is fed to an input to a first input to a summer 72b whose output is fed to an input to a D-type flip-flop 140. The clock terminal of the flip-flop 140 is supplied with a signal at a rate of N.fs and the clear (CLR) terminal of the flip-flop is supplied with a signal having a rate of fs. The output of the flip-flop 140 is fed to a second input to the summer 72b and to the second input to the summer 130. An output 132 of the summer 130 comprises the output of the filter.

By supplying the clear input (CLR) of the flip-flop 138 with a system reset signal as opposed to a signal at a rate of N.fs, a further delay stage prior to the summer 130 or the accumulate stage 128 (Figure 7a) are unnecessary. In the embodiment of the filter shown in Figure 4 the flip-flops were cleared once every iteration. The system reset connection to the CLR input of the flip-flop 138 has the effect of adding the last phase output to the current phase output from the iterative system. The contents of the flip-flop 138 will only be cleared upon a system start-up or reset. A filter as shown in Figure 7a may thus be implemented in a simple manner.

The scalar constants k1,k2 may be determined by reference to the text by Rabiner and Gold referenced earlier. If the scalar constants in any of these systems by which the angular displacements have been premultiplied or by which the feedback signals are scaled need to be altered from time to time then a master ROM could be provided whose output could be multiplied by a scalar constant and the result stored in at least two look-up tables comprising Random Access Memories (RAMs). These RAMs would then replace the ROMs 70a,70b (Figure 4), the ROMs 100,102 (Figure 5) or the ROMs 100,102,110. The same principle is applicable to the ROM 116 (Figure 6).

A radio receiver in accordance with the present invention may comprise one or more superheterodyne stages provided that a quadrature mixing stage is incorporated before the exponential multiplier or other quadrature mixing arrangement to provide the quadrature related signals which are required by the CORDIC algorithm.

From reading the present disclosure, other variations will be apparent to persons skilled in the art. Such variations may involve other features which are already known in the design, manufacture and use of filtering arrangements and component parts thereof and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

## Claims

1. A filtering arrangement for a digital signal represented by a plurality of bits, comprising at least a first look-up table and a second look-up table which are both addressed by the said plurality of bits, the first look-up table containing a plurality of data values premultiplied by a first scalar constant and the second look-up table containing the plurality of data values premultiplied by a second scalar constant, an output of the first look-up table being coupled to a first input of a signal combining means, an output of the second look-up table being coupled to the input of a delay means, an output of the delay means being coupled to a second input of the signal combining means and the output of the signal combining means comprising an output of the filtering arrangement.

2. An arrangement as claimed in Claim 1, characterised in that the output of the signal combining means is coupled to at least one further delay means and the outputs of the further delay means are coupled to further inputs to the signal combining means.

3. An arrangement as claimed in Claim 2, characterised in that a scaling means is included in series with each of the further delay means.

4. An arrangement as claimed in any one of Claims 1 to 3, characterised in that the digital signal represented by the plurality of bits comprises an output of an iterative system for one iterative step, a first summing means is connected between the output of the first look-up table and the signal combining means, a second summing means is connected between the output of the second look-up table and the delay means, the first and second summing means being operable to add the outputs of the iterative system over a complete set of iterative steps.

5. A filtering arrangement for a digital signal represented by a plurality of bits which comprises the output of an iterative system, comprising at least a first look-up table and a second look-up table which are both addressed by the said plurality of bits, the first look-up table containing a plurality of data values premultiplied by a first scalar constant and the second look-up table containing the plurality of data values premultiplied by a second scalar constant, an output of the first look-up table being coupled to an input of a first summing means whose output is coupled to a first input of a signal combining means, an output of the second look-up table being coupled to an input of a second summing means whose output is coupled to a second input of the signal combining means, the summing means being operable to add the outputs of the iterative system over at least a complete set of iterative steps and at least one of the summing means being operable to add a respective output of the iterative system over a plurality of sets of iterative steps, and the output of the signal combining means comprising an output of the filtering arrangement.

6.   An arrangement as claimed in any one of Claims 1 to 5, characterised in that at least one of the look-up tables is dynamically alterable, and in that the scalar constants by which the contents of the look-up table have been premultiplied may be altered in operation to alter characteristics of the arrangement.

7.   A radio receiver comprising at least a first frequency down conversion stage for providing quadrature related outputs, a further frequency down conversion stage having signal inputs connected to receive the quadrature related outputs of the first frequency down conversion stage, the further frequency down conversion stage comprising a local oscillator having a control input and a pair of quadrature related outputs and a means for multiplying the signal inputs and the local oscillator outputs to provide a first and a second output in phase quadrature, the outputs of the further frequency down conversion stage being coupled to inputs of first and second filtering means respectively, an output of the first filtering means comprising an output of the receiver and being fed to a first input of a phase detection and filtering means, an output of the second filtering means being fed to a second input of the phase detection and filtering means which has an output coupled to the control input of the local oscillator, the output signals from the first and second filtering means comprising an input phasor to the first and second inputs of the phase detection and filtering means, characterised in that the phase detection and filtering means comprises means for rotating the input phasor to produce an intermediate phasor which lies in one of two adjacent angular quadrants, means for rotating the intermediate phasor in a series of iterative steps through a plurality of successively decreasing angular displacements towards an axis common to the two adjacent angular quadrants, means for counting the index number of each iterative step and applying the index number to at least two look-up tables containing entries which are equal to products of the angular displacements premultiplied by different scalar constants, means for modulating the polarity of the outputs of the at least two look-up tables in response to the direction of the angular displacement for each iterative step and at least a first and a second means coupled to the look-up tables for summing their outputs over a complete series of iterative steps, the output of the first summing means is coupled to the input of a delay means whose output is coupled to an input to a signal combining means, the output of the second summing means is coupled to another input of the signal combining means, the output of the signal combining means is coupled to at least one further delay means, the output of the or each further delay means is coupled to the or a respective further input of the signal combining means and the output of the signal combining means comprises the output of the phase detection and filtering means.

8.   A receiver as claimed in Claim 7, characterised in that the at least two look-up tables contain the products and the inverses of the products of premultiplied angular displacements, and in that the means for modulating the polarity of the outputs of the look-up tables in response to the direction of the angular displacement for each iterative step comprises an input to each look-up table.

9.   A receiver as claimed in Claim 7 or 8, characterised in that the means for modulating the polarity of the outputs of at least one of the look-up tables in response to the direction of the angular displacement for each iterative step comprises a polarity reversible input of each of the summing means which are coupled to the outputs of the look-up tables.

10.  A receiver as claimed in any one of the Claims 7 to 9, characterised in that at least one of the look-up tables is dynamically alterable, whereby the scalar constants by which the contents of the at least one look-up table have been premultiplied may be altered in operation to alter the filtering characteristics of the phase detection and filtering means.

FIG.1

FIG.2

FIG.5

FIG.3

EP 0 481 543 A1

FIG.4

FIG.6

FIG.7

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | GEC JOURNAL OF RESEARCH (INCORPORATING MARCONI.REVIEW.) vol. 7, no. 1, 1989, CHELMSFORD GB pages 8 - 15; JAMES: 'A digitally implemented QPSK modem operating at up to 10 Mbit/s' * page 12, right column, line 16 - line 23 * * page 14, left column, line 12 - line 31 * * page 14, left column, line 52 - right column, line 10; figures 7,9,11 * | 1,5,7 | H03H17/02 |
| A | EP-A-0 032 253 (E-SYSTEMS) * page 11, line 25 - page 12, line 8 * * page 12, line 29 - page 13, line 18; figures 3,5B * | 1,5,7 | |
| A | EP-A-0 078 101 (ITT INDUSTRIES) * abstract * * page 10, line 17 - line 25; figures 3,4 * | 1,5,7 | |
|  | | | TECHNICAL FIELDS SEARCHED (Int. Cl.5) |
|  | | | H03H H04L |

The present search report has been drawn up for all claims

| Place of search | Date of completion of the search | Examiner |
|---|---|---|
| THE HAGUE | 13 FEBRUARY 1992 | WRIGHT J.P. |

EPO FORM 1503 03.82 (P0401)